# EUROPEAN PATENT SPECIFICATION

(11) **EP 4 334 133 B1**
(45) Date of publication and mention of the grant of the patent: **12.02.2025**
(21) Application number: 22727355.4
(22) Date of filing: 03.05.2022
(51) Int. Cl.: B32B 37/12, B32B 37/20, H05K 3/04

(54) **IMPROVED ROLL-TO-ROLL PROCESSING METHOD**
VERBESSERTES ROLL-TO-ROLL-VERARBEITUNGSVERFAHREN
PROCÉDÉ ROULEAU À ROULEAU AMÉLIORÉ

(30) Priority: 04.05.2021 FI 20215517
(43) Date of publication of application: 13.03.2024
(73) Proprietor: THE WARMING SURFACES COMPANY OY, 90500 Oulu (FI)
(72) Inventor: HIETALA, Mikko, 90571 Oulu (FI); KOLOLUOMA, Terho, 90571 Oulu (FI); HUTTUNEN, Arttu, 90571 Oulu (FI)
(74) Representative: Boco IP Oy Ab
(86) International application number: PCT/FI2022/050291
(87) International publication number: WO 2022/234189

(56) References cited:
- DE-A1- 102009 033 510
- US-A- 4 091 125
- US-A- 5 645 932
- US-A- 5 645 932
- US-A1- 2006 213 609
- US-A1- 2006 213 609
- US-A1- 2007 012 775
- US-A1- 2007 012 775
- US-A1- 2013 032 283
- US-A1- 2013 032 283
- US-A1- 2014 338 739
- US-A1- 2014 338 739
- US-B1- 10 842 025
- US-B1- 10 842 025
- US-B2- 9 307 650
- US-B2- 9 307 650

## Description

### FIELD OF THE DISCLOSURE

This invention relates to roll-to-roll processing methods, and particularly to a roll-to-roll processing method for providing a conductive element on a receiving carrier web.

### BACKGROUND

Fabrication of thin conductive elements on various types of carriers has been under keen interest and much progress has been made in the field. For example, a significant number of solutions for electronic article surveillance and radio-frequency identification purposes have been developed and described in patent literature. Typically, in these solutions, an antenna is fabricated by cutting through a laminate formed of a metal foil and a reinforcing underlay and a reinforced sheet carrying the antenna is then adhesively attached on a receiving carrier. This is naturally a practical approach when the effect on mechanical properties of the receiving carrier or to the thickness of the receiving carrier by the transferred element are not important.

However, there are many applications where the receiving carrier needs to be elastic and/or stretchable so that it can be, for example, comfortably worn. In some applications the receiving carrier needs to have a web-like form so that it can be roll-to-roll processed but is also elastically deformable so that it appropriately follows contours and deformations of a curved surface on which it is to be subsequently fixed. In these type of applications, additional reinforcing and/or carrier layers between the conductive element and the receiving carrier are simply not acceptable. For example, when a patterned element formed of a layer of conductive metal and a layer of reinforcing paper material is placed on a fabric, the fabric no longer bends in a way it should in order to be comfortably worn. This is especially the case if the surface covered by the conductive element is large like, for example, in applications where the conductive element is designed to deliver heat through a fabric web. On the other hand, it is considered practically not possible to make a patterned metal element robust enough to endure transfer onto the receiving carrier without the reinforcing underlay and at the same time to adequately maintain the elastic properties of the receiving carrier when attached to it.

Deformability of the receiving carrier is not the only characteristic that is compromised by an intermediate layer under the conductive element. In a broad range of applications, thickness or coverage of the element placed on the receiving carrier is of importance and use of additional reinforcing sheets to transfer the conductive element on such receiving carrier web is problematic or even impossible. This is the case with, for example, functional conductive elements laminated on or between layers of kraft paper. The conductive element introduced into the laminate needs to be as thin as possible to avoid adverse effect to the appearance and functionality of the laminate.

On the other hand, in some applications electronic devices are integrated with materials that provide overall structural strength of a laminate body. In such applications, maintaining this structural integrity of the body is very important. In a body that includes structural materials such as fiber enforced composites, a conductive element for an electronic functionality could be placed between reinforcing fiber layers. An additional carrier or reinforcing layer for the electronic functionality would create additional material boundaries within the body and prevent the composite polymer to form physical and/or chemical bonds continuously through the carrier or reinforcing layer. The structural integrity of the body would thus be very negatively affected.

Another conventional approach to attach a conductive element on a receiving carrier has been to pattern the conductive element directly onto it. In these applications, pervasive methods like laser cutting, die-cutting or even kiss-cutting are out of the question, because the risk of damaging the underlying receiving carrier is too high. Printing methods, like inkjet printing, offset printing, screen printing, flexography and gravure printing have been used in applications where the conductive element is thin, and the receiving carrier is not a deformable and/or porous web. However, they are not well suitable for depositing a conductive element to a web of fibres. For example, the porous surface of such web absorbs printed material unevenly, so the printed form of the conductive element is typically not accurate enough.

US 2014/0338739 A1 discloses a roll-to-roll processing method for manufacturing an integrated back-sheet for a back contact photovoltaic module with a metal foil circuit adhered to a polymer substrate.

### BRIEF DESCRIPTION

An object of the present disclosure is to provide a solution that solves or at least alleviates the above challenges in providing conductive elements on many types of carrier webs.

The object of the invention is achieved by a method as stated in independent claim 1. Some embodiments of the invention are disclosed in the dependent claims.

The disclosed embodiments are based on the idea of operating systematically with two different types of adhesives in selected stages of the roll-to-roll processing. An advantage of the proposed solutions is that a very thin element of conductive material can be accurately and reliably transferred to adhesively attach on a carrier surface.

### BRIEF DESCRIPTION OF THE DRAWINGS

In the following, the disclosure will be described in greater detail by means of examples with reference to the accompanying drawings, in which
Figure 1 illustrates stages of an example of a roll-to-roll processing method;
Figure 2 shows an exploded view to layers of the roll-to-roll processed web;
Figure 3 illustrates stages of an alternative example of a roll-to-roll processing method;
Figure 4 illustrates in simplified form stages of the roll-to-roll process described in detail with Figure 1;
Figure 5 illustrates stages of a further alternative way to bind the top surfaces of the one or more conductive elements to a first carrier web;
Figure 6a illustrates layers of the roll-to-roll processed web that is fed into the patterning stage in the embodiment described with Figures 1 and 5;
Figure 6b illustrates layers of the roll-to-roll processed web that is fed into the patterning stage in the embodiment described with Figure 3;
Figure 7 illustrates layers of an exemplary product resulting from the exemplary roll-to-roll processing method described with Figures 1 and 5;
Figure 8 illustrates layers of an exemplary product resulting from the exemplary roll-to-roll processing method described with Figure 3;
Figures 9a and 9b illustrate an exemplary product resulting from the roll-to-roll processing method;
Figure 10 illustrates stages of a further alternative roll-to-roll processing method wherein the initial adhesive force of the releasably binding adhesive is reduced;
Figure 11 illustrates stages of an alternative example of a roll-to-roll processing method;
Figure 12 shows an exemplary dual-laminate product resulting from the method described with Figure 11.

### DETAILED DESCRIPTION

Roll-to-roll processing is a fabrication method used for manufacturing products. In a roll-to-roll process a web of materials can be continuously fed from one reel onto another and at the same time materials can added to the progressing web or removed from it to produce a desired product.

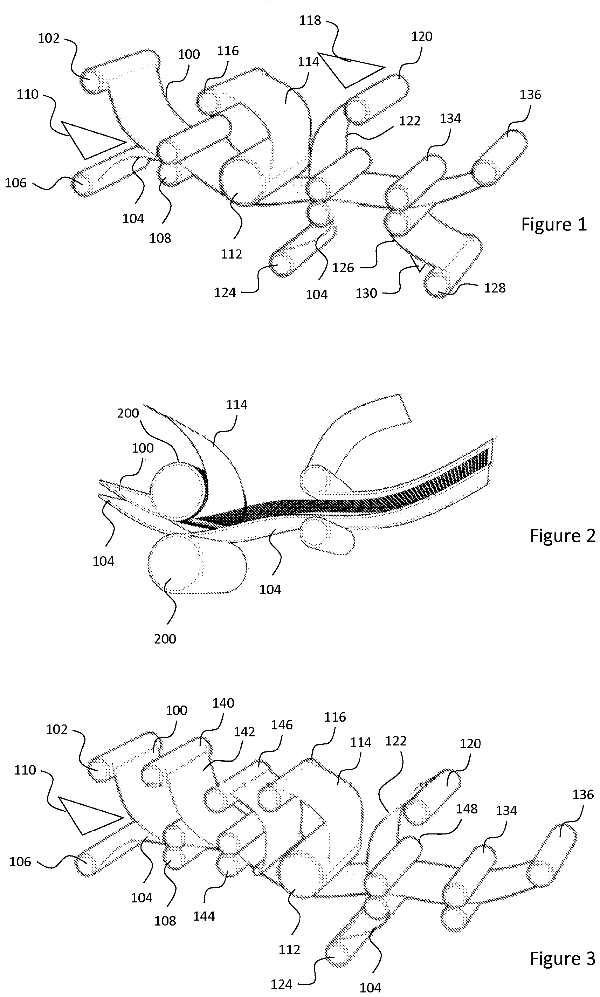

Figure 1 illustrates stages of an example of a roll-to-roll processing method applying the claimed invention. It is to be noted that the drawings included in this specification are schematic figures, which show only structural elements that are necessary to explain the non-restrictive examples of the claimed method. It is clear that implementations of the roll-to-roll processing method may include several additional stages and conventional parts that are well known to a person skilled in the art and will thus not be discussed in detail herein.

The roll-to-roll processing method disclosed in this text includes patterning boundaries of one or more conductive elements into a layered web that includes a conducting layer and a first substrate layer bound to each other with a first adhesive. Boundaries of one or more conductive elements are patterned so that said patterning includes cutting the boundaries through the conducting layer but not through the first substrate layer. Parts of the conducting layer outside the boundaries of the one or more conductive elements are removed from the first substrate layer and top surfaces of the one or more conductive elements to a second substrate layer with a second adhesive. In the end, a resulting layered web that includes at least the second substrate and the conductive elements is rolled on a reel.

In the example of Figure 1, the first substrate layer is a sacrificial substrate layer and the first adhesive is a releasably binding adhesive. The second substrate is a first carrier layer and the second adhesive is a carrier binding adhesive. The term layer refers in this text to an elongate web of material that can be rolled around a reel for a roll-to-roll process. Accordingly, a conducting layer refers here to an elastic elongate sheet with a tensile strength that enables it to be roll-to-roll processed as a continuous web but is thin and thus flexible enough to not have substantial effect on mechanical properties of an underlying surface when attached to it. The conducting layer may be made of a material (e.g. metal) that provides both the required conductivity and the required tensile strength, but for the required conductivity, the conducting layer typically includes a very thin layer of conductive material on a thin polymer web.

The conductive material may be metal or some metal composition including conductive metals. Examples of such conductive metals include aluminum, copper, silver, platinum, palladium, zinc, nickel, gold, chromium, iron, molybdenum and equals and their alloys. Also conductive allotropes of carbon, or some semiconductor materials, like silicon, germanium, gallium arsenide, can be used as the conductive material, specifically when doped for higher conductivity.

The polymer web may include plastics based on polymers, their copolymers and mixtures, for example, poly(ethylene terphtalate), poly(naphtalene), poly(methyl methacrylate), poly(imide), poly(ethylene), cyclo-olephinic polymers and -co-polymers, thermoplastic urethane, poly(carbonate), poly(propylene), poly(vinyl chloride), poly(tetra fluoro ethane) and similar, silicones, or the like. In order to appropriately conform to the deformations of the receiving carrier, the thickness of the layer of conductive material is of the order of 0.5 to 50 micrometers and the thickness of the polymer film is of the order of 10 to 250 micrometers. In some examples, the layer of conductive material is of the order of 10 to 30 micrometers and the thickness of the polymer film is of the order of 10 to 125 micrometers. In some other layer structures, the layer of conductive material is of the order of 10 to 20 micrometers and the thickness of the polymer film is of the order of 20 to 50 micrometers. Very successful applications have been made with, for example, a conducting layer that contains a 12 micrometer layer of aluminum on a 36 micrometer layer of polyethylene terephthalate (PET), but the manufacturing process described herein enables application of even thinner conducting layers. With thicknesses in this range, the polymer film provides at least 90 % of the tensile strength of the conducting layer. As noted above, unlike a reinforcing paper layer, this type of polymer film can be provided with a thickness that provides a necessary tensile strength for transferring the conducting layer laminate as such from reel to reel and also to appropriately endure the force required to release the adhesion of the releasably binding adhesive. Even so, the conducting layer is still thin and flexible enough to not notably compromise web-like mechanical properties, like flexibility, of the receiving carrier when finally fixed on it. It has been detected that to be durable enough for efficient processing, paper materials need to be so thick that their existence on a flexible receiving carrier significantly stiffens the web-like form, and thus makes the resulting receiving carrier unsuitable for purposes where elastic conformity is required. Furthermore, use of reinforcing sheet of paper tends to be problematic for applications, where added thickness by the conductive element needs to be minimized.

The sacrificial substrate layer refers here to a reinforcing layer on which the conducting layer remains releasably bonded through patterning and material releasing stages that will be described in detail later in this text. Advantageously the sacrificial substrate layer is the reinforcing element that provides more than 60% of the tensile strength of the layered web and is therefore considerably (at least two times) thicker than the conducting layer. Examples of applicable materials for the sacrificial substrate layer include plastics based on polymers, their copolymers and mixtures, for example, poly(ethylene terphtalate), poly(naphtalene), poly(methyl methacrylate), poly(imide), poly(ethylene), cyclo-olephinic polymers and o-polymers, thermoplastic urethane, poly(carbonate), poly(propylene), poly(vinyl chloride), poly(tetra fluoro ethane) and similar, silicones, or the like. Very successful implementations have already been made with, for example, a sacrificial substrate layer of 0.08 millimeter polyester film. The sacrificial substrate layer may also include some other reinforcing material, like a paper sheet that is covered with a thin layer of plastic materials, like the ones listed above.

The sacrificial substrate layer and the conducting layer are laminated into a temporary composite structure by gluing their surfaces to each other with a releasably binding adhesive. Releasably binding adhesive in this context refers to any adhesive that binds the sacrificial substrate layer and the conducting layer to each other so that they remain fastened while boundaries of a conductive element are pattered into the conducting layer, but so that the adhesion of the releasably binding adhesive can be released by pulling the surfaces of the sacrificial substrate layer and the conducting layer away from each other with a force that does not break either of the layers. Examples of releasably binding adhesives include silicones, acrylates, epoxides, urethanes, or poly(vinyls) that can be deposited on the sacrificial substrate layer by lamination, spraying, coating, printing or as a hotmelt glue.

In the example of Figure 1, the conducting layer 100 is rolled out of one reel 102 and the sacrificial substrate layer 104 is rolled out of another reel 106 and the layers are pressed on each other with nip rolls 108. Alternatively, the layers 100, 104 can be laminated to each other in beforehand, and fed to the roll-to-roll process in a readily laminated form. In the example of Figure 1, the sacrificial substrate layer 104 is covered by a layer of the releasably binding adhesive. In this example, the roll-to-roll process is shown to include a spray station 110 in which the releasably binding adhesive is spread on the sacrificial substrate layer after it is rolled out the reel 106. However, the mechanism for providing the releasably binding adhesive is not relevant, as such. Examples of other applicable deposition methods include flexography, gravure, wire printing, off-set printing, screen printing, slot-die and reverse-gravure, among others. The sacrificial substrate layer may even be provided as readily covered with releasably binding adhesive and a protective sheet that is reeled off before the sacrificial substrate layer is fed into the process. The essential aspect is that the releasably binding adhesive is provided between a surface of the conducting layer 100 and a surface of the sacrificial substrate layer 104 so that when the surfaces are put into contact, the releasable adhesion activates or can be activated to releasably bind the surfaces to each other. Accordingly, the releasably binding adhesive can alternatively be deposited on a surface of the conducting layer. Activation of the releasably binding adhesive refers here to any function that completes the binding effect of the releasably binding adhesive. Examples of applicable activation methods to bond an adhesive with the adherent include, for example, application of pressure, enabling contact, cooling, heating, radiation, to mention some.

Even if the adhesion is to be released, the strength of the adhesion of the releasably binding adhesive needs to be strong enough to support the very thin conducting layer during the cutting operation so that the boundaries of the resulting pattern are accurate. Advantageously, the layer of conductive material provides the surface of the conducting layer that is put against the surface of the sacrificial substrate layer. The polymer film becomes then positioned to the side in which the patterning cuts through the conducting layer. This provides a protecting effect that ensures that the resulting pattern, which is cut from the layer of conductive materials, is more accurately in the designed form.

Figure 1 illustrates the patterning stage with a cutting tool 112. A cutting tool that patterns a layered web by means of force typically includes a die that shears the layered web to a predefined depth. Here the patterning is configured to cut the boundaries of conductive elements through the conducting layer but not through the sacrificial substrate layer. This kind of cutting method is known in the field as kiss-cutting. The die of a kiss-cutting tool may be, for example, a rotary flexible die or a solid die. However, alternative kiss-cutting mechanisms may be applied within the scope. For example, a beam of a high-power laser can be directed on the layered web for the purpose of laser-cutting through the conducting layer but not through the sacrificial substrate layer.

Figure 1 provides a simplified illustration of a cutting tool 112, an example of which is discussed in more detail with Figure 2. Figure 2 shows an exploded view to layers of the roll-to-roll processed web and exemplary parts of the cutting tool. For a person skilled in the art it is clear that during operation, the shown elements are pressed against or adhesively attached to each other. The cutting tool may include a cutting reel 200 and an anvil reel 202. The cutting reel 200 includes at least one cutting die, typically a matrix of dies that extend to a defined distance from the cutting reel 200. During operation, the cutting reel is rotated and pressed against the anvil reel 202. Between the rotating cutting reel 200 and the anvil reel 202 is a depth dimensioning mechanism that controls the distance between the rotating wheel 200 and the anvil reel 202, and thus adjusts the cutting depth at a predefined level. A simple example of a depth dimensioning mechanism is a set of height-adjustable rigid sleeves that run in the edge of the anvil reel and during operation stop the cutting reel into abutment with their adjusted height. As can be seen both in Figure 1 and Figure 2, the boundaries of the conductive elements form a continuous pattern so that after the patterning stage, the conductive elements are separated from the conducting layer as single elements and the parts of the conducting layer outside these boundaries form a continuous recessed web 114.

Returning back to Figure 1, the recessed web 114 can be removed from the roll-to-roll processed web by releasing it from the sacrificial substrate layer and rolling it on a release reel 116 that is offset from the direction of progress of the roll-to-roll processed web. The parts of the conducting layer, which form the recessed web, become thus pulled away from the sacrificial substrate layer with a force that exceeds adhesion of the releasably binding adhesive. This is enabled by the tensile strength of the conducting layer, in this example, the tensile strength of the polymer film, and the appropriately weak adhesion of the releasably binding adhesive. It is noted that even if the adhesion is to be released, the adhesion needs to be strong enough to support the very thin conducting layer during the cutting operation so that accuracy of the boundaries of the resulting pattern is adequate. On the other hand, the releasably binding adhesive needs to be weak enough to enable release of the recessed web 114.

After removal of the recessed web, the roll-to-roll processed web includes the sacrificial substrate layer and conductive elements attached on it with the releasably binding adhesive. In more detail, bottom surfaces of the conductive elements are bound to the sacrificial substrate layer with the releasably binding adhesive, and top surfaces of the conductive elements are exposed. These top surfaces can then be bound to a first carrier layer, which is now a receiving carrier, with a carrier binding adhesive. The example of Figure 1 shows an exemplary embodiment wherein a film of the carrier binding adhesive is formed first on the first carrier layer 122. This is illustrated by showing a spray station 118 in which the releasably binding adhesive is spread on the first carrier layer after it is rolled out the reel 120. However, as discussed, in this example, the mechanism for providing the carrier binding adhesive is not relevant, as such. The essential aspect is that the carrier binding adhesive is provided between a surface of the first carrier layer 122 and top surfaces of the conductive elements so that when these surfaces are put into contact, the more permanent carrier binding adhesive can be activated to bind the surfaces to each other. The other essential aspect is that the two adhesives are selected or otherwise arranged so that adhesion between the conductive elements and the first carrier layer by the carrier binding adhesive is stronger than adhesion between the conductive elements and the sacrificial substrate layer by the releasably binding adhesive.

The first carrier layer 122 preferably includes a web of fibres on which at least one conductive element is to be attached. The web of fibres may be a woven web formed of a network of interlocked fibres or a non-woven web formed of fibres bonded together by chemical, mechanical, heat or solvent treatment. Said fibres can include natural or synthetic, for example, animal based fibres (e.g. hair, fur, skin, silk, etc.), plant-based fibres (e.g. pulpwood trees, cotton, straw, bamboo, etc.), mineral based fibres (e.g., basalt, glass, metal) or synthetic fibres (e.g. polyester, aramid, acrylic, nylon, carbon, etc.). As discussed above, forming conductive elements on such woven or non-woven webs of fibres has so far been considered very problematic, because there has not been a suitable method to transfer and fix a separate cut-out conductive element on the web of fibres without a stiff reinforcing underlay, which disrupts the elastic properties of the web of fibres. The method is naturally applicable for other types of webs, as well.

The term carrier binding adhesive refers in this context to any adhesive that does not harden in use and forms a strong adhesion between the first carrier layer 122 and the top surfaces of the conductive elements. Essentially, the adhesion by the carrier binding adhesive is stronger than the adhesion between the bottom surfaces of the conductive elements and the sacrificial substrate layer 104 formed with the releasably binding adhesive. Examples of the carrier binding adhesives include silicones, acrylates, epoxides, urethanes, poly(vinyls), to mention some. Accordingly, when the top surfaces of the conductive elements are put into contact with the layer of the carrier binding adhesive on the first carrier layer, adhesion of the carrier binding adhesive can be activated so that the conductive elements become firmly bonded to the surface of the first carrier layer 122.

Now that the top surfaces of the conductive elements have been transferred and firmly glued on the first carrier layer without interfering mechanically stiffening elements, the sacrificial substrate layer can be removed from the one or more conductive elements. Due to the higher adhesive bond between the first carrier layer 122 and the top surfaces of the conductive elements than between the bottom surfaces of the conductive elements and the sacrificial substrate layer 104, this can be implemented simply by pulling the sacrificial substrate layer 104 away from the one or more conductive elements with a reel 124 that is offset from the direction of the roll-to-roll processed web. This creates a force that exceeds adhesion of the releasably binding adhesive but not the adhesion of the carrier binding adhesive. The stronger adhesion of the carrier binding adhesive keeps the conductive elements secured on the first carrier layer 122 while the releasably binding adhesive lets the sacrificial substrate layer to be released from the bottom surfaces of the conductive elements.

After this stage, the roll-to-roll processed web includes only the conductive elements easily transferred and now firmly bound on the first carrier layer 122 without intermediate stiffening sheets, like reinforcing paper layers, that would adversely affect the elastic properties or structural integrity of the first carrier layer or increase the thickness of the resulting laminate. The resulting combination could already be used as a product that contains a receiving carrier and one or more conductive elements. However, Figure 1 illustrates further optional stages that can be used to provide a laminate wherein the conductive element is fixed between two carrier layers, still without intermediate stiffening and height increasing elements.

As shown in Figure 1, the roll-to-roll process can include a further stage wherein the bottom surfaces of the one or more conductive elements are bound to a third substrate layer with a third adhesive. The bottom surfaces of the one or more conductive elements are surfaces of the conducting layer exposed by removing the first substrate layer from them.

In the example of Figure 1, said third substrate layer is a second carrier layer 126 and the third adhesive is the carrier binding adhesive. As shown in Figure 1, the second carrier layer can be rolled off a reel 128 and a layer of the carrier binding adhesive be applied on a surface of the second carrier layer. This is illustrated by showing a spray station 130 in which the releasably binding adhesive is spread on the second carrier layer after it is rolled out the reel 128. However, as mentioned earlier, in this example, the mechanism for providing the carrier binding adhesive is not relevant, as such. Alternative deposition methods include flexograph-, gravure-, offset or screen printing, slot-die or reverse gravure coating, for example. The essential aspect is that the carrier binding adhesive is provided between a surface of the second carrier layer 128 and bottom surfaces of the conductive elements so that when these surfaces are put into contact between reels 134, the carrier binding adhesive can be activated to bind the surfaces to each other. The resulting laminate can then be rolled as a final dual-laminate product on a transfer reel 136.

Figure 3 illustrates an embodiment showing an alternative way to bind the top surfaces of the one or more conductive elements to a first carrier layer with a carrier binding adhesive. Elements and stages that were shown and explained in Figure 1 are denoted in Figure 3 with same reference numbers and are not described with this drawing again, further details on these elements can be referred from the description of Figure 1. In the embodiment of Figure 3, a layer of the carrier binding adhesive is formed on the layered web before the patterning stage. Furthermore, the top surfaces of the one or more conductive elements are bound to the first carrier layer by activating adhesion of the carrier binding adhesive after the patterning stage where boundaries of the conductive elements are patterned into the layered web but before the removing stage where the parts of the conducting layer outside the boundaries of the one or more conductive elements are removed from the sacrificial substrate layer.

An advantageous method to implement this is to use pressure sensitive adhesive (PSA) as the carrier binding adhesive. Examples of PSA adhesives include acrylic and silicone based PSA tapes. Many of the PSA products can be roll-to-roll processed, and they are also well applicable in die-cutting and kiss-cutting processes because they typically appear in solid but elastic form that is easy to cut and does not spatter or stick on the cutting tools. It has been detected that specifically acrylic-based PSA products are of the type that provides an appropriate adhesive strength for the purpose. In practise this means that the adhesion by acrylic-based PSA is so much stronger than the adhesive strength of the releasably binding adhesive that it keeps the conductive elements fixed to the first carrier layer even when the sacrificial substrate layer is released by pulling it away from them.

In practise, in order to be roll-to-roll processed, a PSA tape needs to be covered with a release liner, like a silicone covered polymer film. Figure 3 shows an implementation where the roll-to-roll process disclosed in Figure 1 includes a further PSA reel 140 from which a PSA tape 142, which includes a layer of PSA material covered with a release liner is rolled on the layered sheet that rolls out of the nip rolls 108. The PSA tape is oriented so that the layer of PSA material gets into contact with the conducting layer conductor layer of the layered web and the release liner is on the top. The layered web and the PSA tape are pressed together with nip rolls 144, which activates the PSA material, and forms the strong adhesion to the conducting layer in layered web. The release liner can then be removed as a continuous sheet with a reel 146, as shown in Figure 3. The PSA material now forms the carrier binding adhesive, covers the conducting layer, and becomes patterned with it in the cutting tool 112. Parts of the PSA material layer become also removed from the process with the removable parts of the conducting layer when the recessed web is released from the sacrificial substrate layer by means of the reel 116.

Accordingly, after the cutting and recessed web removal stages, the roll-to-roll processed web includes the sacrificial substrate layer and the conductive elements. Bottom surfaces of the conductive elements are bound to the sacrificial substrate layer with the releasably binding adhesive, and top surfaces of the conductive elements are covered with a layer of PSA material. When the roll-to-roll processed web is now put into contact with the first carrier layer 122 rolling out of reel 120 and pressed on it with nip rolls 148, the top surfaces of the conductive elements become strongly fixed to the first carrier layer 122, and the sacrificial substrate layer 104 can be pulled off by rolling it onto the reel 124, as described in Figure 1. The adhesion by the releasably binding adhesive is so much weaker than the adhesion by the PSA material of the carrier binding adhesive that the conductive elements remain fixed to the first carrier layer while the sacrificial substrate layer 104 is released from the roll-to-roll processed web. The process may optionally include a further pair of nip rolls 134 to finalise the desired lamination and the final product that includes the flexible web of the first carrier sheet with flexible conductive elements without stiffening and/or height increasing reinforcing layers can then be rolled onto a transfer reel 136.

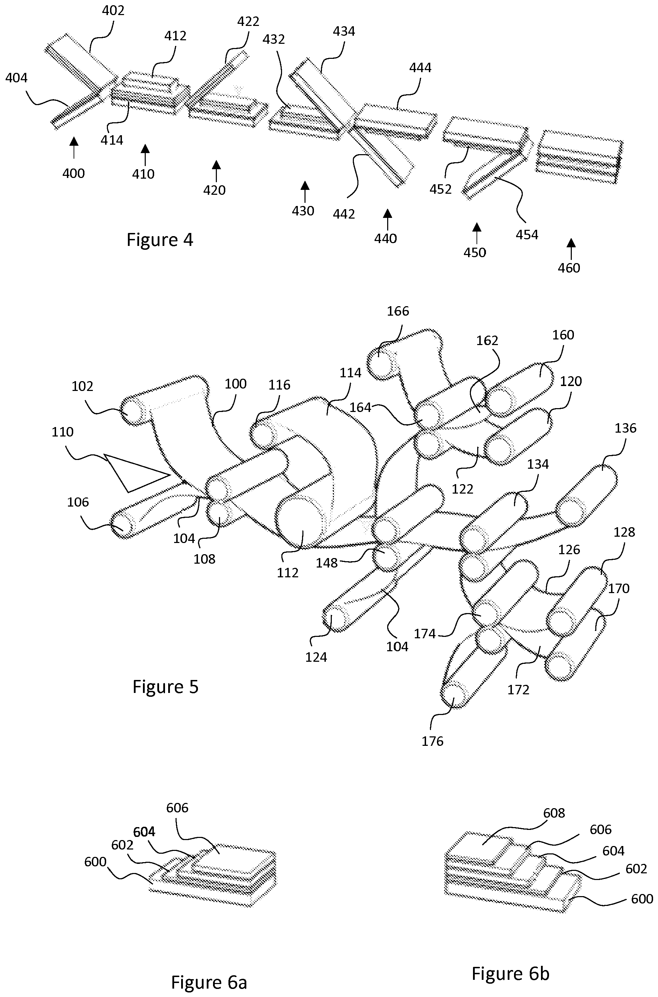

Figure 4 illustrates in simplified form stages of the roll-to-roll process described in detail with Figure 1. Further details for the terms and elements discussed herein may be referred from the description of Figure 1. In stage 400, the layered web is formed by binding the conducting layer 402 and the sacrificial substrate layer 404 to each other with the releasably binding adhesive. Stage 410 illustrates the patterning stage wherein a cutting tool 412 patterns boundaries of the conductive elements into the layered web 414 by cutting though the conducting layer but not through the sacrificial substrate layer. Stage 420 illustrates removal of the recessed web 422, formed of the parts of the conducting layer outside the boundaries of the one or more conductive elements from the sacrificial substrate layer. Stage 430 illustrates binding the exposed top surfaces 432 of the conductive elements to the first carrier layer 434, which is covered with the carrier binding adhesive. Stage 440 illustrates removal of the sacrificial substrate layer 442 from the one or more conductive elements while the top surfaces of the one or more conductive elements are already bound to the first carrier layer 444. Stage 450 illustrates the optional function to create a dual-sided laminate by binding the exposed bottom surfaces 452 of the conductive elements to the second carrier layer 454, which is covered with the carrier binding adhesive. Stage 460 illustrates rolling of the resulting dual-layer product that includes one or more flexible conductive elements laminated inside two flexible fibrous webs.

Figure 5 illustrates an embodiment showing a further alternative way to bind the top surfaces of the one or more conductive elements to a first carrier layer with a carrier binding adhesive so that roll-to-roll processable PSA material can be used as a carrier binding adhesive in both adhesive layers of a dual-laminate product. Elements and stages that were shown and explained in Figures 1 and 3 are denoted in Figure 5 with same reference numbers and are not described with this drawing again, further details on these elements can be referred from the description of Figures 1 and 3. In the embodiment of Figure 5, a layer of the carrier binding adhesive is a PSA tape that it is rolled from a reel onto the conductive elements after the patterning stage. The top surfaces of the one or more conductive elements are bound to the first carrier layer before the removing stage where the parts of the conducting layer outside the boundaries of the one or more conductive elements are removed from the sacrificial substrate layer.

Figure 5 shows an implementation where the roll-to-roll process disclosed in Figures 1 and 3 includes a further PSA reel 160 from which a PSA tape 162, which includes a layer of PSA material covered with a release liner is rolled on the first carrier layer 122 rolling out of reel 120. The first carrier layer 122 and the PSA tape are pressed together with nip rolls 164, which activates the PSA material, and forms the strong adhesion to the first carrier layer 122. The release liner can then be removed as a continuous sheet with a reel 166, as shown in Figure 5. The PSA material layer now forms the carrier binding adhesive, and is exposed so that when it is rolled with the roll-to-roll progressing web by the nip rolls 148, the PSA material activates, and forms the strong adhesion between the first carrier layer 122 and the top surfaces of the conductive elements.

The roll-to-roll processed web includes now the sacrificial substrate layer, the conductive elements, and the first carrier layer 122. The bottom surfaces of the conductive elements are bound to the sacrificial substrate layer with the releasably binding adhesive, and top surfaces of the conductive elements are fixed to the first carrier layer 122. The sacrificial substrate layer 104 can then be pulled off by rolling it onto the reel 124, as described in Figure 1. The adhesion by the releasably binding adhesive is so much weaker than the adhesion by the PSA material of the carrier binding adhesive that the conductive elements remain fixed to the first carrier layer while the sacrificial substrate layer 104 et is released from the roll-to-roll processed web. The process may optionally include a further pair of nip rolls 134 to finalise the desired lamination and the final product that includes the flexible web of the first carrier layer with flexible conductive elements without stiffening and/or height increasing reinforcing layers can then be rolled onto a transfer reel 136.

As shown in Figure 5, the roll-to-roll process in this embodiment can include a further stage wherein a second carrier layer 126 is rolled off a reel 128 and a layer of PSA material is rolled on a surface of the second carrier layer. This is illustrated with a further PSA reel 170 from which a PSA tape 172, which includes a layer of PSA material covered with a release liner is rolled on the second carrier layer 126. The second carrier layer 126 and the PSA tape 172 are pressed together with nip rolls 174, which activates the PSA material, and forms the strong adhesion to the second carrier layer 126. The release liner can then be removed as a continuous sheet with a reel 176, as shown in Figure 5. The resulting laminate can then be rolled as a final dual-laminate product on a transfer reel 136.

Figure 6a illustrates layers of the roll-to-roll processed web that is fed into the patterning stage (cutting tool 112 in Figure 1, stage 410 in Figure 4) in the embodiment described with Figures 1 and 4. The layered web has a first layer 600 that includes the sacrificial substrate layer (denoted as 104 in Figure 1 and 404 in Figure 4). A second layer 602 includes the releasably binding adhesive. The third layer 604 includes the layer of conductive material in the conducting layer, and the fourth layer 606 includes the polymer film covering the layer of conductive material in the conducting layer.

Figure 6b illustrates layers of the roll-to-roll processed web that is fed into the patterning stage (cutting tool 112 in Figure 3) in the embodiment described with Figure 3. The layered web has a first layer 600, the second layer 602, the third layer 604 and the fourth layer 606 described with Figure 6a, but also a fifth layer 608 that includes the layer of PSA material that is used as the carrier binding adhesive. The PSA material provides the strong adhesion between the conducting layer 604, 606 and the first carrier layer that binds the patterned conductive elements to the first carrier layer and keeps them fixed also during removal of the first layer 600 from the roll-to-roll processed web.

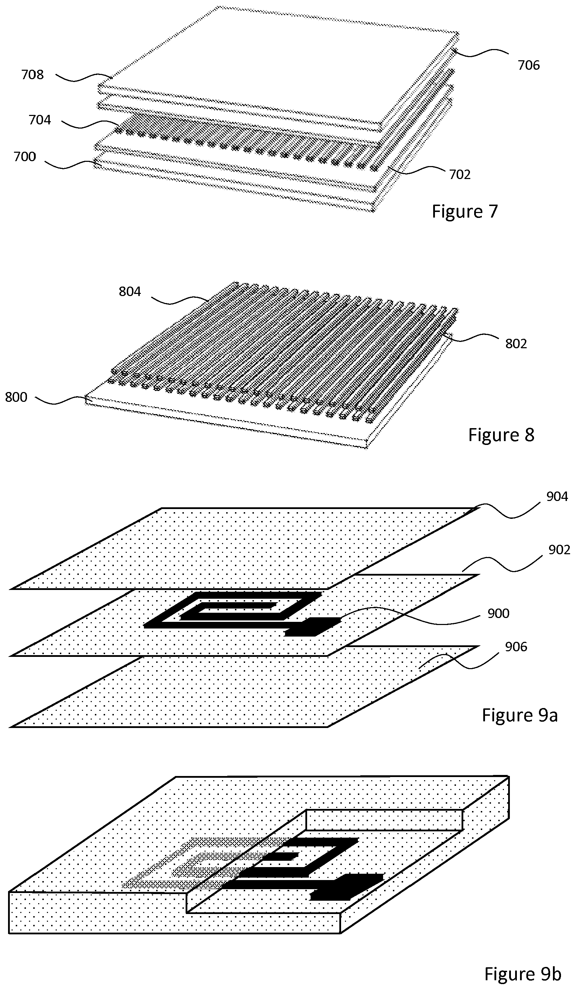

An example product resulting from the roll-to-roll processing methods described in this text is an object that includes a web of fibres and at least one patterned conducting layer adherently bound to the web of fibres with an adhesive. Figure 7 shows an exploded view of layers of an exemplary dual-laminate product resulting from the exemplary roll-to-roll processing method described with Figures 1 and 5. The product includes at least a first woven or non-woven web of fibres 700 (cf. first carrier layer of Figures 1 and 5) to which a patterned conducting layer 704 is adhesively fixed with a first layer of carrier binding adhesive 702. The product may also include a second woven or non-woven web of fibres 708 (cf. second carrier layer of Figures 1 and 5) to which the conducting layer 704 is adhesively fixed with a second layer of carrier binding adhesive 706. The adhesive layers 702, 706 may be formed of a pressure sensitive adhesive tape, or of some other type of non-hardening glue that can be deposited directly on the web of fibres to receive the conductive element in a roll-to-roll processing method.

Figure 8 shows an exploded view of layers of an exemplary product resulting from the exemplary roll-to-roll processing method described with Figure 3. The product includes a first woven or non-woven web of fibres 800 (cf. first carrier layer of Figure 3) to which a patterned conducting layer 804 is adhesively fixed with a first layer of carrier binding adhesive 802. As noted in the description of Figure 3, the carrier binding adhesive 802 is advantageously formed of a layer of pressure sensitive material, and has a patterned form that is equal and aligned to the patterned form of the patterned conductive element.

Figures 9a and 9b illustrate an exemplary product resulting from the roll-to-roll processing method described in this text. Figure 9a shows layers of a high pressure laminate (HPL) that may be made of a plurality of layers of resin-impregnated kraft paper, covered by a protective overlay. The layers of HPL are typically manufactured under high pressure, and in high temperatures. HPL is has many uses in commercial and residential projects like benchtops, vanity tops, tables, counters and more. Such products could be greatly enhanced with an integrated electronic device, for example a heater element seamlessly integrated inside the laminate layers. However, the integrated electronic device needs to be very thin so that it does not disrupt the HPL laminate formation. As discussed earlier, the conductive element itself can be made very thin, but conventional methods known from radio frequency identification solutions where the thin antenna is transferred on carrier on a reinforcing paper sheet are not suitable for this purpose. The roll-to-roll process described in this text enables the arrangement shown in Figures 9a and 9b, wherein a heater element is directly fixed on a kraft paper carrier sheet with an adhesive, without intermediate reinforcing underlay sheets that remain in the resulting laminate product.

Figure 9a shows an electrical component 900, for example a heater element, which is now directly glued on a carrier layer 902 with an adhesive. The carrier layer 902 is a web of fibres, in this specific HPL example, a kraft paper sheet that may the same composition as the other layers 904, 906 used to form layers of the laminate. In production, the plurality of layers 902, 904, 906, which now include the layer 902 that carries the electronic component 900, are impregnated with resin and exposed to a predefined pressure in a predefined temperature (typically of the order of 1000kg per-square-meter of pressure, under 140°C+ temperatures) to form an integrated laminate structure that is illustrated in Figure 9b. Since the electrical component is applied directly on the carrier layer, the added thickness to the laminate formation is minimal. This means that the functional improvement can be provided to the laminate structure without essentially compromising its original look and form.

Figures 9a and 9b can be considered to describe also a fiber reinforced composite, wherein a patterned conductive element 900 for an electronic functionality is placed between reinforcing fiber layers 902, 904. It is easily seen that an additional carrier or reinforcing layer for the electronic functionality would create an additional material boundary within the body formed of laminate layers 902, 904, 906, ... In the absence of such underlay, the composite polymer can penetrate also through parts of the pattern and the reduction of physical and/or chemical bonds is minimised. The structural integrity of the body can thus be maintained, which is very important.

A non-restrictive list of examples of the woven or non-woven elastically deforming webs include textiles, glass-fiber sheets, carbon-fiber sheets, paper sheets, polymer webs and webs of mixtures of these such as aramids, polyolefins (especially ethylene and propylene), liquid crystal polymers, nylon, lycra, cotton, cellulose. A non-restrictive list of examples of conductive elements include heating elements, antennas, conductive tracks, electrodes, current collectors, ground level layers. These can be combined to form, for example, textiles that include a heating element, laminate flooring elements with integrated heaters, fiber enforced composites with integrated heaters, antennas, conductive tracks and current collecting structures, to mention some.

As noted in the description of Figure 1, the adhesion needs to be strong enough to support the very thin conducting layer during the cutting operation to ensure accuracy of the boundaries of the resulting pattern. On the other hand, the releasably binding adhesive needs to be weak enough to enable release of the recessed web of the removable part of the conducting layer, and the sacrificial substrate layer. These two requirements are controversial, and for some structural configurations and roll-to-roll process parameters, it may be difficult to fulfil both requirements with one type of releasably binding adhesive. In a further exemplary embodiment, the roll-to-roll process is configured to include a stage wherein the initial adhesive force of the releasably binding adhesive is reduced before either of the removing stages. Accordingly, the adhesive force may be reduced already before the parts of the conducting layer outside the boundaries of the conductive elements are removed from the sacrificial substrate layer, or then before the conductive elements are removed from the sacrificial substrate layer.

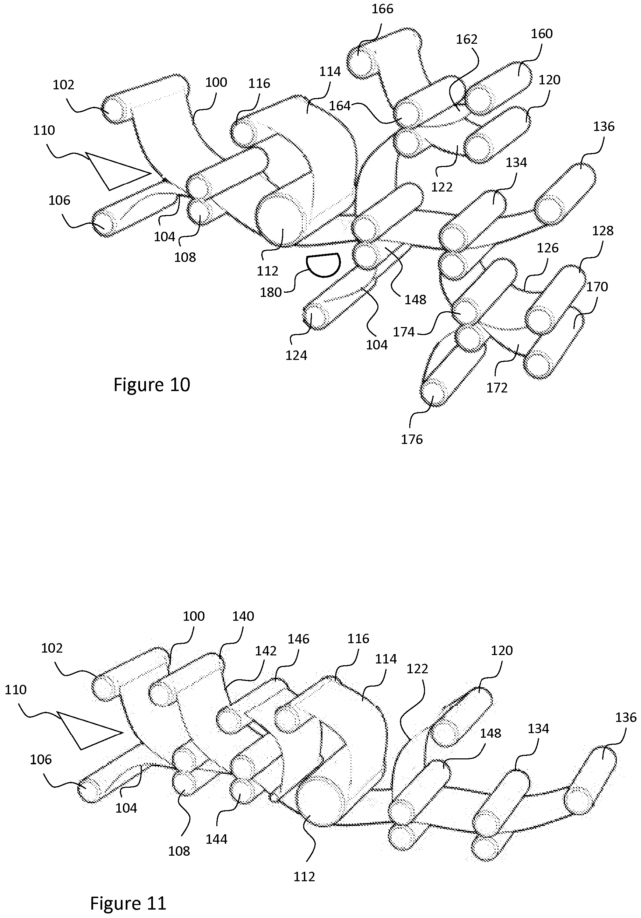

Figure 10 illustrates an example embodiment of the latter option. Elements and stages that were shown and explained in Figure 5 are denoted in Figure 10 with same reference numbers and are not described with this drawing again. Further details on these elements can be referred from the description of any of the previous Figures. In the embodiment of Figure 10, the layer of the carrier binding adhesive is a PSA tape 162 that it is rolled from the reel 120 onto the first carrier layer 122 and binds the top surfaces of the one or more conductive elements to the first carrier layer before the sacrificial substrate layer removing stage.

Figure 10 shows an implementation where the roll-to-roll processing method includes a component 180 for a pre-releasing stage wherein the initial adhesive force of the releasably binding adhesive is reduced. In Figure 10 the component 180 is shown in a position after the cutting tool 112 and after the recessed web 114 has been removed. However, the component 180 may be alternatively arranged to a position where it acts upon the roll-to-roll processed web after the cutting tool 112 but before the recessed web 114 is removed. Such component may be, for example, a source of ultraviolet light, but some other chemical or physical process (e.g. heating, use of a solvent) capable of reducing the adhesive force of an adhesive may be applied within the scope. There exists a group of adhesive materials, that behave otherwise as PSA materials but whose adhesion can be deactivated or at least reduced by exposing the adhesive to ultraviolet light. For example, a commercially available adhesive material behaves like a normal PSA with an adhesive force between 18-32 N/25mm².This supports the described kiss-cutting stage with rather high mechanical forces. Before either of the removal stages, the roll-to-roll progressing web can be exposed to ultraviolet light and this exposure can reduce the adhesive force even down to <0.1 N/25mm². The stronger initial adhesion provides the support of the sacrificial support layer to the patterned film at the patterning stage, and thus improves the result of the patterning. On the other hand, the reduced adhesion at the time of removal of the extra parts of the conducting layer or the sacrificial substrate layer ensures that removal causes minimal adverse effects to the web that remains in the roll-to-roll progressing process.

In the previous examples, the web to be rolled onto a transfer reel 136 includes a carrier layer (e.g. fabric, laminate layer, etc.) to which the conductive element is designed to remain adhesively bound. Figure 11 illustrates a further implementation wherein the method disclosed herein is used to create a layered web that enables transfer of large and fragile conductive elements onto a surface selected by the user on site without creating considerable profiles or intermediate top or bottom substrate layers onto the surface. Concrete examples of such use cases include retrofitting large but thin electrical components on 3D formed windmill blades or on planar surfaces like interior walls or floors of buildings. Elements and stages that were shown and explained in Figure 3 are denoted in Figure 11 with same reference numbers and are not described with this drawing again, further details on these elements can be referred from the description of, for example, Figures 1 and 3.

As in the previous examples, boundaries of one or more conductive elements are patterned into a layered web that includes a conducting layer 100 bound to a first substrate layer 104 with a first adhesive. In the example of Figure 11, the first substrate layer 104 is a protective film that can remain attached to the one or more conductive elements until they are transferred to a target surface. Advantageously, the first substrate layer is a transparent polymer film so that the one or more conductive elements can be accurately positioned when they are transferred to the target surface. The first adhesive is a releasably binding adhesive, which may be deposited on the first substrate layer in the process, as shown in Figure 11, or may be readily provided on the polymer film with a protective sheet that is reeled off before the first substrate layer 104 is fed into the process. In the example of Figure 11, the conducting layer 100 is rolled out of one reel 102 and the first substrate layer 104 is rolled out of another reel 106 and the layers are pressed on each other with nip rolls 108. Alternatively, the layers 100, 104 can be laminated to each other in beforehand, and fed to the roll-to-roll process in a readily laminated form.

As in the embodiment of Figure 3, a layer of the second adhesive is formed on the layered web before the patterning stage. Furthermore, after the patterning stage where boundaries of the conductive elements are patterned into the layered web but before the removing stage where the parts of the conducting layer outside the boundaries of the one or more conductive elements are removed from the first substrate layer, top surfaces of the one or more conductive elements are bound to the second substrate layer by activating adhesion of the second adhesive.

An advantageous method to implement this is to use roll-to-roll transferable pressure sensitive adhesive (PSA) tape as the carrier binding adhesive. The constitution and form of a tape enables patterning of the second adhesive with patterning of the conductive elements. In order to be roll-to-roll processed, a PSA tape may need to be covered with a release liner, like a silicone covered polymer film. Figure 11 shows an implementation where the roll-to-roll process includes a further PSA reel 140 from which a PSA tape 142, which includes a layer of PSA material covered with a release liner is rolled on the layered sheet that rolls out of the nip rolls 108. The PSA tape is oriented so that the layer of PSA material gets into contact with the conducting layer of the layered web and the release liner is on the top. The layered web and the PSA tape are pressed together with nip rolls 144, which activates the PSA material, and forms the strong adhesion to the conducting layer in the layered web. The release liner can then be removed as a continuous sheet with a reel 146, as shown in Figure 11. The PSA material now forms the carrier binding adhesive, covers the conducting layer, and becomes patterned with it in the cutting tool 112. Parts of the PSA material layer become also removed from the process with the removable parts of the conducting layer when the recessed web is released from the sacrificial substrate layer by means of the reel 116.

Accordingly, after the cutting and recessed web removal stages, the roll-to-roll processed web includes the first substrate layer and the conductive elements. Bottom surfaces of the conductive elements are bound to the first substrate layer with the first adhesive, and top surfaces of the conductive elements are covered with a piece of PSA material. When the roll-to-roll processed web is now put into contact with the second substrate layer 122 rolling out of reel 120 and pressed on it with nip rolls 148, the top surfaces of the conductive elements become strongly fixed to the second substrate layer 122. Advantageously, the first substrate layer 104 and the second substrate layer 122 are both formed of a transparent polymer film so that the one or more conductive elements can be accurately positioned when they are transferred to a selected target surface. It is now understood that the cutting tool 112 cuts the conductive elements and the second adhesive into a same patterned form. The second adhesive that bonds the top surfaces of the conductive elements in this example is thus a piece of pressure sensitive adhesive with a patterned form that is equal and aligned to the form of the patterned conductive element. Parts of the second substrate layer between the conductive elements are not covered by the second releasably binding adhesive. This means that the resulting layered web does not include parts where two adhesive layers would be glued to each other.

The process may optionally include a further pair of nip rolls 134 to finalise the desired lamination and the final product that includes fragile conductive elements secured between the two protective substrate layers can then be rolled onto a transfer reel 136.

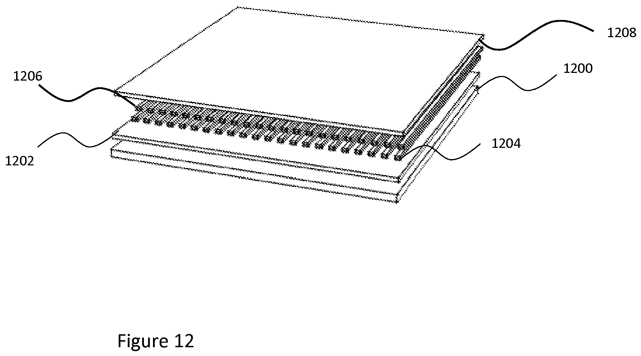

Figure 12 shows an exploded view of layers of an exemplary dual-laminate product resulting from the exemplary roll-to-roll processing method described with Figure 11. The layered web includes a first substrate layer 1200 covered with a thin layer of first adhesive 1202. The combination of the first substrate layer and the first adhesive may be provided by, for example, a silicone covered, transparent polymer film. The layered web also includes a conductive element 1204 and a piece of second adhesive 1206 with a patterned form that is equal and aligned to the patterned form of the patterned conductive element 1204. The topmost layer is the second substrate layer 1208.

When the conductive element is transferred on a selected surface, advantageously the second substrate layer 1208 is removed first. This means that the first adhesive 1202 and the second adhesive 1206 are selected so that adhesion provided by the pattern of second adhesive 1206 between the top surfaces of the one or more conductive elements 1204 and the second substrate 1208 is weaker than adhesion provided by the first adhesive 1202 between bottom surfaces of the conductive elements 1204 and the first substrate layer 1200. Since the first and second adhesives are not in contact and the second adhesive 1206 covers only the conductive element 1204, the second substrate layer is easily removed from the layered web, and the first substrate layer 1200 further supports the fragile conductive element during the removal. The second adhesive 1206 remains attached to the conductive element 1204 and so the conductive element can be pressed on a target surface so that an adhesive bond is formed. Again, as the conductive element 1204 is attached to the target surface, it remains fully supported by the first substrate layer 1200 so even very large conductive elements that include very thin and thus easily wrinkling parts can be safely transferred on any surface. When the adhesive contact of the second adhesive has again been activated by pressing and smoothing the conductive element against the target surface, the first substrate layer 1200 can be pulled off so that only the conductive element remains attached to the target surface.

The examples described herein are schematic and non-restrictive illustrations of elements and terms necessary to disclose the invention. For a person skilled in the art it is clear that the described deposition stages have various possible implementation options that are covered as long as within the scope of the appended claims.

## Claims

1. A roll-to-roll processing method, comprising:
binding (400) a conducting layer (100) and a first substrate layer (104, 1200) formed of a transparent polymer film to each other with a first adhesive (1202);
attaching a layer of second adhesive (1206) on the conducting layer (100);
patterning (410) boundaries of one or more conductive elements (900, 1204), said patterning cutting the boundaries through the layer of second adhesive (1206) and the conducting layer (100) but not through the first substrate layer (104, 1200);
removing (420) parts of the conducting layer (100) and parts of the layer of second adhesive (1206) outside the boundaries of the one or more conductive elements (900, 1204) from the first substrate layer (104, 1200);
binding (430) top surfaces of the one or more conductive elements (900, 1204) to a second substrate layer (122, 1208) formed of a transparent polymer film with the layer of second adhesive (1206) patterned into a same patterned form as a patterned form of the one or more conductive elements (900, 1204);
rolling (460) a layered web (414) on a reel, the layered web including the one or more conductive elements (900, 1204) attached to the first substrate layer (104, 1200) with the first adhesive (1202), and to the second substrate layer (122, 1208) with the layer of second adhesive (1206), which is patterned into the same patterned form as the patterned form of the one or more conductive elements (900, 1204).

2. A method according to claim 1, **characterized by** said patterning including kiss-cutting or laser cutting through the conducting layer (100) and the layer of second adhesive (1206).

3. A method according to any of the preceding claims, **characterized in that** the conducting layer (100) includes a layer of conductive metal and a polymer layer.

4. A method according to any of the preceding claims 1 to 3, **characterized by** removing (440) the parts of the conducting layer (100) and the parts of the second adhesive (1206) by pulling said parts away from the first substrate layer (104, 1200) with a force that exceeds adhesion of the first adhesive (1202).

5. A method according any of the preceding claims, **characterized by** patterning (410) the boundaries of the one or more conductive elements (900, 1204) through the conducting layer (100) and through the layer of second adhesive (1206) so that parts of the conducting layer (100) and the layer of second adhesive (1206) to be removed from the first substrate layer (104, 1200) in form a recessed web (114, 422);
rolling the recessed web (114, 422) onto a reel (116) of a first roll-to-roll element to provide the force pulling the parts of the conducting layer (100) and the layer of second adhesive (1206) away from the first substrate layer (104, 1200).

6. A method according to any of the preceding claims, **characterized by** arranging the first adhesive (1202) and the second adhesive (1206) so that adhesion provided by the second adhesive (1206) between the top surfaces of the one or more conductive elements (900, 1204) and the second substrate layer (122, 1208) is weaker than adhesion provided by the first adhesive (1202) between bottom surfaces of the one or more conductive elements and the first substrate layer (104, 1200).

7. A method according to any of the preceding claims, **characterized by** forming the layer of second adhesive (1206) from a pressure sensitive adhesive.

## Patentansprüche

1. Rolle-zu-Rolle-Bearbeitungsverfahren, umfassend:
Gegenseitiges Verbinden (400) einer leitenden Schicht (100) und einer aus einem transparenten Polymerfilm ausgebildeten ersten Substratschicht (104, 1200) mit einem ersten Klebstoff (1202);
Anbringen einer Schicht von zweitem Klebstoff (1206) auf der leitenden Schicht (100);
Strukturieren (410) von Konturen eines oder mehrerer leitfähiger Elemente (900, 1204), wobei beim Strukturieren die Konturen durch die Schicht von zweitem Klebstoff (1206) und die leitende Schicht (100) hindurch, aber nicht durch die erste Substratschicht (104, 1200) hindurch geschnitten werden;
Entfernen (420) von Teilen der leitenden Schicht (100) und Teilen der Schicht von zweitem Klebstoff (1206) außerhalb der Konturen des einen oder der mehreren leitfähigen Elemente (900, 1204) weg von der ersten Substratschicht (104, 1200);
Verbinden (430) von oberseitigen Flächen des einen oder der mehreren leitfähigen Elemente (900, 1204) mit einer aus einem transparenten Polymerfilm ausgebildeten zweiten Substratschicht (122, 1208) mittels der Schicht von zweitem Klebstoff (1206), die in eine gleiche strukturierte Form wie eine strukturierte Form des einen oder der mehreren leitfähigen Elemente (900, 1204) strukturiert wird;
Aufrollen (460) einer geschichteten Bahn (414) auf eine Spule, wobei die geschichtete Bahn das eine oder die mehreren leitfähigen Elemente (900, 1204) umfasst, die an der ersten Substratschicht (104, 1200) mit dem ersten Klebstoff (1202) und an der zweiten Substratschicht (122, 1208) mit der Schicht von zweitem Klebstoff (1206), angebracht sind, die in die gleiche strukturierte Form wie die strukturierte Form des einen oder mehreren leitfähigen Elemente (900, 1204) strukturiert wird.

2. Verfahren nach Anspruch 1, **gekennzeichnet dadurch, dass** das Strukturieren umfasst: Kiss-Cutting oder Laserschneiden durch die leitende Schicht (100) und die Schicht von zweitem Klebstoff (1206) hindurch.

3. Verfahren nach einem der vorhergehenden Ansprüche, **gekennzeichnet dadurch, dass** die leitende Schicht (100) eine Schicht von leitfähigem Metall und eine Polymerschicht umfasst.

4. Verfahren nach einem der Ansprüche 1 bis 3, **gekennzeichnet durch** Entfernen (440) der Teile der leitenden Schicht (100) und der Teile des zweiten Klebstoffs (1206) durch Abziehen dieser Teile von der ersten Substratschicht (104, 1200) mit einer Kraft, die das Haftvermögen des ersten Klebstoffs (1202) übersteigt.

5. Verfahren nach einem der vorhergehenden Ansprüche, **gekennzeichnet durch** Strukturieren (410) der Konturen des einen oder der mehreren leitfähigen Elemente (900, 1204) durch die leitende Schicht (100) und durch die Schicht von zweitem Klebstoff (1206) hindurch, so dass Teile der leitenden Schicht (100) und der Schicht von zweitem Klebstoff (1206), die von der ersten Substratschicht (104, 1200) zu entfernen sind, eine ausgesparte Bahn (114, 422) ausbilden;
Aufrollen der ausgesparten Bahn (114, 422) auf eine Spule (116) eines ersten Rolle-zu-Rolle-Elements zur Bereitstellung der Kraft, die die Teile der leitenden Schicht (100) und der Schicht von zweitem Klebstoff (1206) von der ersten Substratschicht (104, 1200) abzieht.

6. Verfahren nach einem der vorhergehenden Ansprüche, **gekennzeichnet durch** Anordnen des ersten Klebstoffs (1202) und des zweiten Klebstoffs (1206) dergestalt, dass das vom zweiten Klebstoff (1206) bereitgestellte Haftvermögen zwischen den oberseitigen Flächen des einen oder der mehreren leitfähigen Elemente (900, 1204) und der zweiten Substratschicht (122, 1208) schwächer ist als das vom ersten Klebstoff (1202) bereitgestellte Haftvermögen zwischen den unterseitigen Flächen des einen oder der mehreren leitfähigen Elemente und der ersten Substratschicht (104, 1200).

7. Verfahren nach einem der vorhergehenden Ansprüche, **gekennzeichnet dadurch, dass** die Schicht von zweitem Klebstoff (1206) aus einem drucksensitiven Klebstoff ausgebildet wird.

## Revendications

1. Procédé de traitement rouleau à rouleau, comprenant les étapes consistant à :
relier (400), l'une à l'autre, une couche conductrice (100) et une première couche de substrat (104, 1200) formée d'un film polymère transparent avec un premier adhésif (1202);
attacher une couche de second adhésif (1206) sur la couche conductrice (100);
modeler (410) des contours d'un ou de plusieurs éléments conducteurs (900, 1204), ledit modelage découpant les contours à travers la couche de second adhésif (1206) et la couche conductrice (100) mais non à travers la première couche de substrat (104, 1200);
éliminer (420) de la première couche de substrat (104, 1200) des parties de la couche conductrice (100) et des parties de la couche de second adhésif (1206) à l'extérieur des contours desdits un ou plusieurs éléments conducteurs (900, 1204);
relier (430) des surfaces supérieures desdits un ou plusieurs éléments conducteurs (900, 1204) à une seconde couche de substrat (122, 1208) formée d'un film polymère transparent avec la couche de second adhésif (1206) modelée dans une même forme modelée qu'une forme modelée desdits un ou plusieurs éléments conducteurs (900, 1204);
enrouler (460) une bande multicouche (414) sur une bobine, ladite bande multicouche comprenant lesdits un ou plusieurs éléments conducteurs (900, 1204) attachés à la première couche de substrat (104, 1202) avec le premier adhésif (1202) et à la seconde couche de substrat (122, 1208) avec la couche de second adhésif (1206) qui est modelée dans la même forme modelée que la forme modelée desdits un ou plusieurs éléments conducteurs (900, 1204).

2. Procédé selon la revendication 1, **caractérisé en ce que** ledit modelage comprend le découpage par effleurement ou découpage au laser à travers la couche conductrice (100) et la couche de second adhésif (1206).

3. Procédé selon l'une des revendications précédentes, **caractérisé en ce que** la couche conductrice (100) comprend une couche de métal conducteur et une couche polymère.

4. Procédé selon l'une des revendications 1 à 3, **caractérisé par** l'étape consistant à éliminer (440) les parties de la couche conductrice (100) et les parties du second adhésif (1206) en retirant lesdites parties de la première couche de substrat (104, 1200) avec une force qui dépasse l'adhésivité du premier adhésif (1202).

5. Procédé selon l'une des revendications précédentes, **caractérisé par** l'étape consistant à
modeler (410) les contours desdits un ou plusieurs éléments conducteurs (900, 1204) à travers la couche conductrice (100) et à travers la couche de second adhésif (1206) de telle sorte que des parties de la couche conductrice (100) et de la couche de second adhésif (1206) à éliminer de la première couche de substrat (104, 1200) forment une bande en retrait (114, 422);
enrouler la bande en retrait (114, 422) sur une bobine (116) d'un premier élément rouleau à rouleau pour fournir la force retirant de la première couche de substrat (104, 1200) les parties de la couche conductrice (100) et de la couche de second adhésif (1206).

6. Procédé selon l'une des revendications précédentes, **caractérisé par** l'étape consistant à aménager le premier adhésif (1202) et le second adhésif (1206) de telle sorte que l'adhésivité fournie par le second adhésif (1206) entre les surfaces supérieures desdits un ou plusieurs éléments conducteurs (900, 1204) et la seconde couche de substrat (122, 1208) est plus faible que l'adhésivité fournie par le premier adhésif (1202) entre les surfaces inférieures desdits un ou plusieurs éléments conducteurs et la première couche de substrat (104, 1200).

7. Procédé selon l'une des revendications précédentes, **caractérisé par** l'étape consistant à former la couche de second adhésif (1206) à partir d'un adhésif sensible à la pression.
